# EUROPEAN PATENT APPLICATION

(11) **EP 4 703 801 A1**
(43) Date of publication of application: **04.03.2026**
(21) Application number: 24796900.9
(22) Date of filing: 17.04.2024
(51) Int. Cl.: G03F 7/20, H05G 2/00

(54) **LIGHT SOURCE DEVICE, ILLUMINATION METHOD, AND METHOD FOR MANUFACTURING LIGHT SOURCE DEVICE**

(30) Priority: 24.04.2023 JP 2023070595
(71) Applicant: Lasertec Corporation, Yokohama-shi, Kanagawa 222-8552 (JP)
(72) Inventor: KAWAGUCHI Junya, Yokohama-shi, Kanagawa 222-8552 (JP); TAKAMATSU Takahide, Yokohama-shi, Kanagawa 222-8552 (JP); NISHIZAWA Masayasu, Yokohama-shi, Kanagawa 222-8552 (JP); SEKI Hirokazu, Yokohama-shi, Kanagawa 222-8552 (JP)
(74) Representative: Pfenning, Meinig & Partner mbB
(86) International application number: PCT/JP2024/015341
(87) International publication number: WO 2024/225147

(57) **Abstract**

A light source apparatus (1) according to an embodiment includes: a target material (11) capable of generating EUV light (15) when irradiated with laser light (13); a collector mirror (30) configured to reflect the EUV light (15); an exhaust case (40) including an outer cover (41) disposed between the target material (11) and the collector mirror (30), and an exhaust port (42) communicating with an exhaust space (43) formed on a target material (11) side of the outer cover (41); a cylindrical optical-path cover (50), a diameter of an opening another end (52) being larger than that of an opening at one end (51); and a filter (60) disposed at the other end (52) of the optical-path cover (50) or inside thereof, and configured to let the EUV light (15) pass therethrough, in which purge gas (44) introduced from an intake port (53) formed in the optical-path cover (50) is injected from the one end (51) of the optical-path cover (50) toward the target material (11) and thereby discharged through the exhaust port (42) via the exhaust space (43).

## Description

### Technical Field

The present disclosure relates to a light source apparatus, an illumination method, and a method for manufacturing a light source apparatus.

### Background Art

Each of Non-patent Literatures 1 to 3 discloses a light source that irradiates a target material containing xenon, formed on the surface of a rotating drum with laser light, and generates EUV light from generated plasma.

### Citation List

### Non Patent Literature

[Non-patent Literature 1] "Progress towards Actinic Patterned Mask Inspection", Oleg Khodykin, Workshop Proceedings, 2015 International Workshop on EUV Lithography, June 15, 2015, [Retrieved on March 6, 2023], Internet <https://www.euvlitho.com/2015/P51.pdf>
[Non-patent Literature 2] "Bright and reliable Xe-based EUV source for metrology and inspection applications", Oleg Khodykin, Workshop Proceedings, 2015 International Workshop on EUV and Soft X-Ray Sources, November 9, 2015, [Retrieved March 6, 2023], Internet <https://www.euvlitho.com/2015/S31.pdf>
[Non-patent Literature 3] "Status of Actinic Patterned Mask Inspection at KLA-Tencor", Oleg Khodykin, Workshop Proceedings, 2016 International Workshop on EUV and Soft X-Ray Sources, November 7, 2016, [Retrieved March 6, 2023], Internet <https://www.euvlitho.com/2016/S19.pdf>

### Summary of Invention

As a method for generating EUV light, in addition to the above-mentioned Non-patent Literatures 1 to 3, there is also a method in which a molten metal in a liquid state, containing tin is put in a container such as a crucible, rotating the container, irradiating the molten metal with laser light, and generating EUV light from generated plasma. In any of the above-described methods, optical elements such as mirrors are contaminated due to debris which are formed from the target material such as xenon, tin, or lithium when the plasma is generated. This phenomenon poses a serious problem in EUV light sources.

In the past, methods for mitigating debris by introducing inert gas near the optical path of laser light and/or the mirror have been proposed. However, there is the following problem. That is, EUV light is absorbed by the diffused inert gas and/or a gasified target material, and the formation of debris is not sufficiently mitigated, so that the contamination of optical elements still occurs and hence the amount of EUV light decreases.

The present disclosure has been made to solve such a problem and provides a light source apparatus capable of mitigating the decrease in the amount of EUV light, an illumination method using such a light source apparatus, and a method for manufacturing such a light source apparatus.

A light source apparatus according to an aspect of an embodiment includes: a target material capable of generating EUV light together with plasma when irradiated with laser light; a collector mirror configured to reflect the generated EUV light; an exhaust case comprising an outer cover disposed between the target material and the collector mirror, and an exhaust port communicating with an exhaust space formed on a target material side of the outer cover; a cylindrical optical-path cover having one open end and another open end, a diameter of an opening at the other end being larger than that of an opening at the one end, and the one end facing the target material and the other end being disposed on a collector mirror side of the outer cover; and a filter disposed at the other end of the optical-path cover or inside the optical-path cover, and the filter being configured to let the EUV light pass therethrough, in which purge gas is introduced through an intake port formed in the optical-path cover and injected from the one end of the optical-path cover toward the target material, and discharged through the exhaust port via the exhaust space.

A light source apparatus according to an aspect of an embodiment includes: a target material capable of generating EUV light together with plasma when irradiated with laser light; a collector mirror configured to reflect the generated EUV light; an exhaust case comprising an outer cover disposed between the target material and the collector mirror, and an exhaust port communicating with an exhaust space formed on a target material side of the outer cover; a transmissive member configured to let the laser light pass therethrough; and a cylindrical laser optical-path cover having a one open end and another open end, a diameter of an opening at the other end being larger than that of an opening at the one end, and the one end of the laser optical-path cover facing the target material, and the transmissive member being disposed at the other end of the laser optical-path cover or inside the laser optical-path cover, in which purge gas is introduced from an intake port formed in the laser optical-path cover and injected from the one end of the laser optical-path cover toward the target material and discharged through the exhaust port via the exhaust space.

In the above-described light source apparatus, the outer cover may be configured to separate the exhaust space, in which the target material is disposed, from an optical-path space, in which the collector mirror is disposed.

The above-described light source apparatus may further include: a cylindrical drum configured to rotate about a central axis serving as a rotation axis, and configured to be cooled such that the target material is solidified on its surface; and a supply case comprising a housing having an open portion facing an irradiation position of the laser light, and a supply port communicating with a supply space formed on a target material side of the housing, in which the target material may be formed, as gas for the target material supplied from the supply port solidifies on the surface of the drum.

The above-described light source apparatus may further include: a cylindrical crucible configured to rotate about a central axis serving as a rotation axis, the crucible having one open end and another closed end, and being configured to be heated such that the target material is melted on its inner surface; and a debris shield having an open portion facing an irradiation position of the laser light, in which the target material may be formed by spreading the liquid target material over an inner peripheral surface of the crucible.

An illumination method according to an aspect of an embodiment includes: a step of preparing a light source apparatus comprising: a target material capable of generating EUV light together with plasma when irradiated with laser light; a collector mirror configured to reflect the generated EUV light; an exhaust case including an outer cover disposed between the target material and the collector mirror, and an exhaust port communicating with an exhaust space formed on a target material side of the outer cover; a cylindrical optical-path cover including one open end and another open end, a diameter of an opening at the other end being larger than that of an opening at the one end, and the one end facing the target material and the other end being disposed on a collector mirror side of the outer cover; and a filter disposed at the other end of the optical-path cover or inside the optical-path cover, the filter being configured to let the EUV light pass therethrough; a step of introducing purge gas from an intake port formed in the optical-path cover, injecting the introduced purge gas from the one end of the optical-path cover toward the target material, and discharging the purge gas through the exhaust port via the exhaust space; and a step of generating the EUV light by irradiating the target material with the laser light.

An illumination method according to an aspect of an embodiment includes: a step of preparing a light source apparatus comprising: a target material capable of generating EUV light together with plasma when irradiated with laser light; a collector mirror configured to reflect the generated EUV light; an exhaust case including an outer cover disposed between the target material and the collector mirror, and an exhaust port communicating with an exhaust space formed on a target material side of the outer cover; a transmissive member configured to let the laser light pass therethrough; and a cylindrical laser optical-path cover having one open end and another open end, a diameter of an opening at the other end being larger than that of an opening at the one end, the one end of the laser optical-path cover facing to the target material, and the transmissive member being disposed at the other end of the laser optical-path cover or inside the laser optical-path cover; a step of introducing purge gas through an intake port formed in the laser optical-path cover, injecting the introduced purge gas from the one end of the laser optical-path cover toward the target material, and discharging the purge gas through the exhaust port via the exhaust space; and a step of generating the EUV light by irradiating the target material with the laser light.

In the above-described illumination method, the outer cover may be configured to separate the exhaust space, in which the target material is disposed, from an optical-path space, in which the collector mirror is disposed.

In the above-described illumination method, the light source apparatus may further include: a cylindrical drum configured to rotate about a central axis serving as a rotation axis, and configured to be cooled so that the target material is solidified on its surface; and a supply case comprising a housing having an open portion facing an irradiation position of the laser light, and a supply port communicating with a supply space formed on a target material side of the housing. In the step of preparing the light source apparatus, the target material may be formed by introducing gas for the target material from the intake port into the supply space and solidifying the introduced gas for the target material on the surface of the drum.

In the above-described illumination method, the light source apparatus may further include: a cylindrical crucible configured to rotate about a central axis serving as a rotation axis, the crucible having one open end and another closed end, and being configured to be heated such that the target material is melted on its inner surface; and a debris shield having an open portion facing an irradiation position of the laser light. In the step of preparing the light source apparatus, the target material may be formed by spreading the liquid target material over an inner peripheral surface of the crucible.

A method for manufacturing a light source apparatus according to an aspect of an embodiment includes; a step of preparing a light source apparatus comprising: a target material capable of generating EUV light together with plasma when irradiated with laser light; and a collector mirror configured to reflect the generated EUV light; a step of disposing an outer cover between the target material and the collector mirror, and disposing an exhaust case by forming an exhaust port so that the exhaust port communicates with an exhaust space formed on a target material side of the outer cover; a step of disposing a cylindrical optical-path cover having one open end and another open end, in which a diameter of an opening at the other end is larger than that of an opening at the one end, the one open end facing the target material and the other end is disposed on a collector mirror side of the outer cover; a step of disposing a filter at the other end of the optical-path cover or inside the optical-path cover, the filter being configured to let the EUV light pass therethrough; and a step of forming an intake port through which purge gas is introduced into the optical-path cover.

A method for manufacturing a light source apparatus according to an aspect of an embodiment includes; a step of preparing a light source apparatus comprising: a target material capable of generating EUV light together with plasma when irradiated with laser light; and a collector mirror configured to reflect the generated EUV light; a step of disposing an outer cover between the target material and the collector mirror, and disposing an exhaust case by forming an exhaust port so that the exhaust port communicates with an exhaust space formed on a target material side of the outer cover; a step of disposing a cylindrical laser optical-path cover including one open end and another open end, in which a diameter of an opening at the other end is larger than that of an opening at the one end, the one end of the optical-path cover is facing the target material and the other end of the laser optical-path cover is disposed so as to let the laser light pass therethrough; a step of disposing a transmissive member at the other end of the laser optical-path cover or inside the laser optical-path cover, the transmissive member being configured to let the laser light pass therethrough; and a step of forming an intake port through which purge gas is introduced into the laser optical-path cover.

In the above-described method for manufacturing a light source apparatus, the outer cover may be disposed so as to separate the exhaust space, in which the target material is disposed, from an optical-path space in which the collector mirror is disposed.

In the above-described method for manufacturing a light source apparatus, the light source may further include: a cylindrical drum configured to rotate about a central axis serving as a rotation axis, and configured to be cooled so that the target material is solidified on its surface; and a supply case comprising a housing having an open portion facing an irradiation position of the laser light, and a supply port communicating with a supply space formed on a target material side of the housing. The method may further include a step of forming the target material by introducing gas for the target material from the intake port into the supply space and solidifying the introduced gas for the target material on the surface of the drum.

In the above-described method for manufacturing a light source apparatus, the light source may further include: a cylindrical crucible configured to rotate about a central axis serving as a rotation axis, the crucible having one open end and another closed end, being configured to be heated so that the target material is melted on its inner surface; and a debris shield having an open portion facing an irradiation position of the laser light. The method may further include a step of forming the target material by spreading the liquid target material over an inner peripheral surface of the crucible.

According to the present disclosure, it is possible to provide a light source apparatus capable of mitigating the decrease in the amount of EUV light, an illumination method using such a light source apparatus, and a method for manufacturing such a light source apparatus.

### Brief Description of Drawings

Fig. 1 is a perspective view showing an example of a light source according to a comparative example;
Fig. 2 is a cross-sectional view showing the example of the light source according to the comparative example, schematically showing its cross section taken along a line II-II in Fig. 1;
Fig. 3 is a cross-sectional view showing the example of the light source according to the comparative example, schematically showing its cross section taken along a line III-III in Fig. 1;
Fig. 4 is a cross-sectional view showing the example of the light source according to the comparative example;
Fig. 5 is a cross-sectional view showing an example of a light source apparatus according to a first embodiment;
Fig. 6 is a flowchart showing an example of an illumination method using the light source apparatus according to the first embodiment;
Fig. 7 is a flowchart showing an example of a method for manufacturing a light source apparatus according to the first embodiment;
Fig. 8 is a flowchart showing an example of a flow of purge gas in the light source according to the comparative example;
Fig. 9 is a flowchart showing an example of a flow of purge gas in the light source according to the comparative example;
Fig. 10 is a flowchart showing an example of a flow of purge gas in the light source according to the comparative example;
Fig. 11 is a flowchart showing an example of a flow of purge gas in the light source according to the comparative example;
Fig. 12 is a cross-sectional view showing an example of a light source apparatus according to a second embodiment;
Fig. 13 is a cross-sectional view showing an example of a light source apparatus according to a third embodiment; and
Fig. 14 is a cross-sectional view showing an example of a light source apparatus according to a fourth embodiment.

### Description of Embodiments

Hereinafter, embodiments according to the present disclosure will be described with reference to the drawings. The following description illustrates suitable embodiments of the present disclosure, and the scope of the present disclosure is not limited to these embodiments. In the following description, identical reference signs denote substantially the same components or features.

Prior to describing a light source apparatus according to an embodiment, a light source according to a comparative example will be described in <Comparative Example>. Then, problems identified by the inventors in the light source according to the comparative example will be described in <Problem found by Inventor>. Then, in <First Embodiment> and <Second Embodiment>, light source apparatuses, illumination methods, and methods for manufacturing light source apparatuses according to the embodiments will be described.

### <Comparative Example>

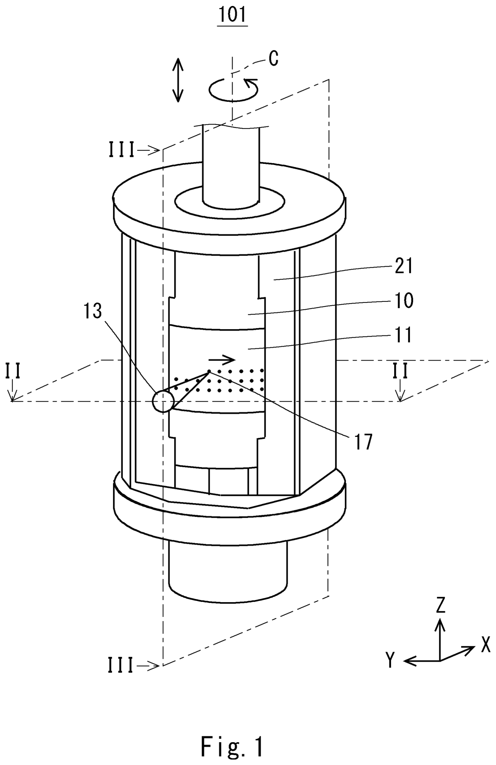

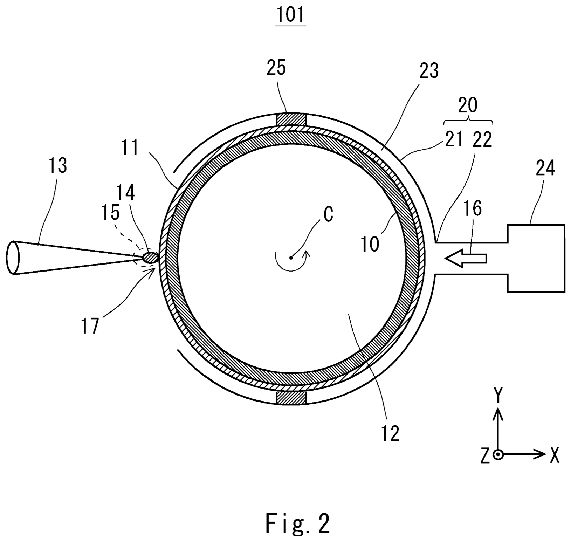

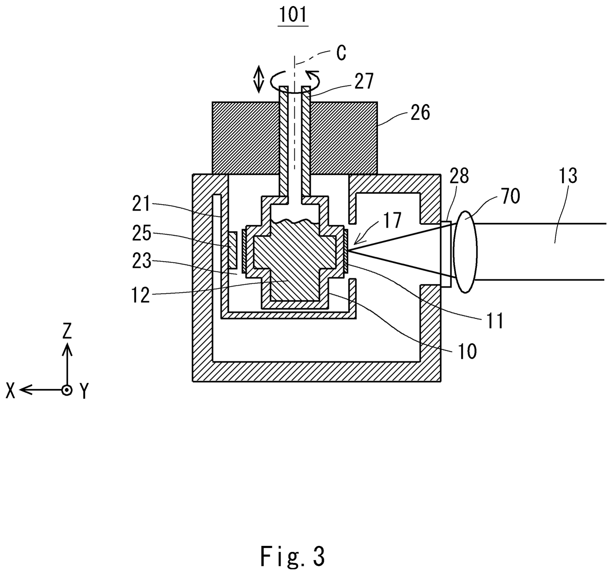

Fig. 1 is a perspective view showing an example of a light source 101 according to a comparative example. Fig. 2 is a cross-sectional view showing the example of the light source 101 according to the comparative example, schematically showing its cross section taken along a line II-II in Fig. 1. Fig. 3 is a cross-sectional view showing the example of the light source 101 according to the comparative example, schematically showing its cross section taken along a line III-III in Fig. 1. Note that some symbols and hatching are omitted to avoid visual complexity.

As shown in Figs. 1 to 3, the light source 101 according to the comparative example includes a drum 10, a target material 11, and a supply case 20. The supply case 20 includes a housing 21 and a supply port 22. Further, the supply case 20 may include a wiper 25, a vacuum seal 26, an intake port 27, and a window 28.

The drum 10 has a cylindrical shape and a central axis C. The drum 10 is configured to rotate about the central axis C, which serves as a rotation axis. Further, the drum 10 may be movable in the direction of the central axis C.

For explanatory purposes of the light source 101, an XYZ orthogonal coordinate system is introduced. The direction in which the central axis C of the drum 10 extends is defined as the Z axis direction. The plane orthogonal to the central axis C of the drum 110 is defined as the XY plane. For example, the +Z axis direction is defined as upward, and the -Z axis direction is defined as downward. Note that these directional definitions provided solely for explanatory purposes of the light source 101, and do not represent the actual installation orientation of the light source 101.

The drum 10 may be made of copper, for example. A coolant 12 such as liquid nitrogen is supplied into the drum 10 to cool it thereby solidifying the target material 11 on its surface. Note that the material of the drum 10 is not limited to copper, and may include any material capable of maintaining the surface temperature of the drum 10 at or below the coagulation point of the target material 11.

The target material 11 generates EUV light 15 as well as plasma 14 when being irradiated with laser light 13. The target material 11 is formed on the surface of the drum 10. The target material 11 includes, for example, xenon (Xe). Note that the material contained in the target material 11 is not limited to xenon, and the target material 11 may instead contain tin (Sn), lithium (Li), or the like as long as it generates EUV light 15 together with plasma 14 when being irradiated with laser light 13.

The supply case 20 includes the housing 21 and the supply port 22. The housing 21 covers the drum 10. The housing 21 is, for example, cylindrical with a hollow interior. The drum 10 is disposed inside the housing 21. The drum 10 rotates inside the housing 21. An open portion of the housing 21 facing the irradiation position 17 of the laser light 13. Therefore, the housing 21 may cover the target material 11 except at the irradiation position 17 of the laser light 13. The housing 21 forms a space on the target material 11 side of the housing 21. The space formed on the target material 11 side of the housing 21 is referred to as a supply space 23.

The supply port 22 communicates with the supply space 23. The supply port 22 is connected to a supply unit 24 for gas 16 for the target material 11. The supply unit 24 supplies the gas 16 for the target material 11 to the supply space 23 via the supply port 22. The gas 16 for the target material 11 supplied from the supply port 22 forms the target material 11 as it solidifies on the surface of the drum 10.

The target material 11, which has solidified on the surface of the drum 10, is irradiated with laser light 13. As a result, plasma 14 is generated from the target material 11. Therefore, EUV light 15 can be generated from the generated plasma 14. The drum 10 rotates about the central axis C and moves along the axis direction. Therefore, the irradiation position 17 of the laser light 13 continuously targets a portion of the target material 11 which has not yet been irradiated with the laser light 13.

The target material 11 may be irradiated with the laser light 13 through a transmissive member 70, such as a condenser lens, and the window 28. The wiper 25 may shape the target material 11, which has solidified on the surface of the drum 10. The vacuum seal 26 seals the interior of the light source 101. The intake port 27 communicates with the interior of the drum 10. Liquid nitrogen is injected into the drum 10 through the intake port 27.

### <Problem Found by Inventor>

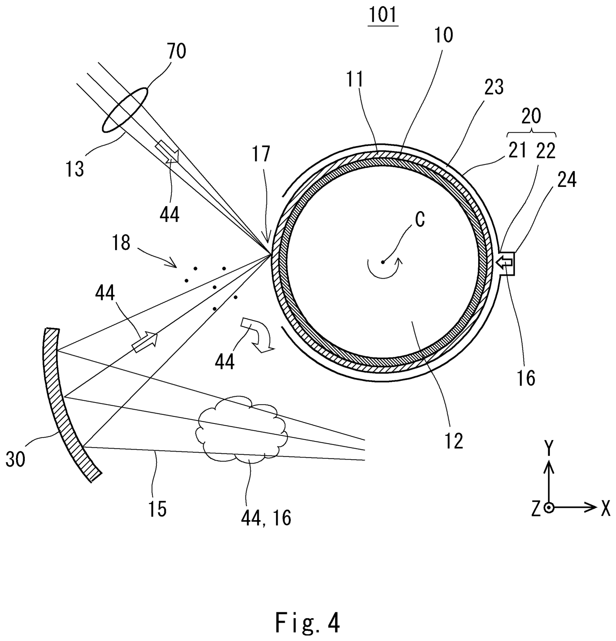

Fig. 4 is a cross-sectional view showing an example of a light source 101 according to a comparative example. As shown in Fig. 4, in the light source 101 according to the comparative example, EUV light 15 generated by irradiating a target material with laser light 13 is reflected by a collector mirror 30 and thereby directed (i.e., led) outside of the light source 101. In some cases, when the EUV light 15 is generated, debris 18 of the target material 11 are generated as a result of the generation of plasma 14. The generated debris 18 adhere to an optical element such as a collector mirror 30 and thereby reduces the amounts of reflected light and transmitted light of the EUV light 15 in the optical element.

Therefore, in some cases, in order to mitigate the adhesion of debris 18 to the optical element, purge gas 44 containing inert gases may be introduced into the optical path of the laser light 13 and around the optical element. The purge gas 44 may include, for example, at least one of argon (Ar), helium (He), nitrogen (N₂), and hydrogen (H₂), or may include other types of gas. However, a problem arises in that the EUV light 15 is absorbed by the diffused purge gas 44 and gas 16 released as the target material 11 is gasified, resulting in reduced EUV light 15. Additionally, there is another problem that the generated debris 18 may not be sufficiently removed which leads to contamination of optical element and further reduces the amount of the EUV light 15.

### <First Embodiment>

Next, a light source apparatus according to a first embodiment will be described. In the light source apparatus according to this embodiment, the optical path of EUV light 15 is maintained in a high vacuum state by limiting the diffusion range of the purge gas 44 and the gas 16 for the target material 11. By doing so, the absorption of the EUV light 15 by the purge gas 44 and the like is reduced and the effect for removing debris 18 is improved.

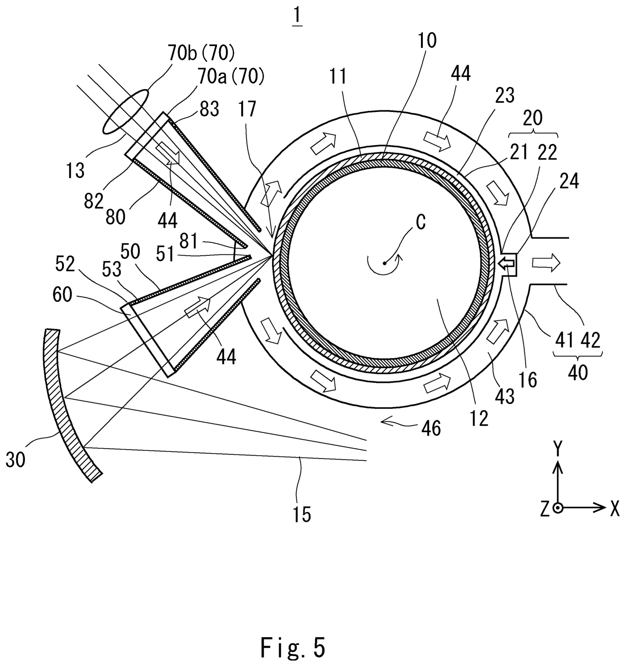

Fig. 5 is a cross-sectional view showing an example of a light source apparatus 1 according to the first embodiment. As shown in Fig. 5, the light source apparatus 1 according to this embodiment includes a drum 10, a target material 11, a supply case 20, a collector mirror 30, an exhaust case 40, an optical-path cover 50, a filter 60, a transmissive member 70, and an optical-path cover 80. The configuration of the drum 10, the target material 11, and the supply case 20 in the light source apparatus 1 is similar to that in the light source 101 according to the comparative example.

The collector mirror 30 reflects the EUV light 15 generated by irradiating the target material 11 with the laser light 13. The collector mirror 30 directs the EUV light 15 to, for example, an illumination optical system of an inspection apparatus. In this way, the inspection apparatus can use the EUV light 15 as inspection light. Note that the collector mirror 30 may direct the EUV light 15 to other optical apparatuses such as an exposure apparatus, instead of the inspection apparatus.

The exhaust case 40 includes an outer cover 41 and an exhaust port 42. The outer cover 41 is disposed between the target material 11 and the collector mirror 30. Specifically, the outer cover 41 includes a part disposed between the target material 11 and the collector mirror 30. The outer cover 41 may cover the supply case 20. In this embodiment, the outer cover 41 has a cylindrical shape with a hollow interior. The supply case 20 is disposed inside the outer cover 41. The outer cover 41 forms a space on the target material 11 side of the outer cover 41. The space formed on the target material 11 side of the outer cover 41 is referred to as an exhaust space 43.

The exhaust port 42 communicates with the exhaust space 43. Further, the exhaust port 42 may be connected to an exhaust pump. In this way, air or the like in exhaust space 43 can be exhausted through the exhaust port 42.

The optical-path cover 50 is disposed between the target material 11 and the collector mirror 30. The optical-path cover 50 has a tubular shape. The optical-path cover 50 may have a conical or truncated conical shape with a hollow interior. For example, the optical-path cover 50 has a cylindrical shape including one open end 51 and the other open end 52. Further, the width (or diameter) of the opening at the other end 52 is larger than that of the opening at the one end 51, and the width (or diameter) of the optical-path cover 50 gradually increases from the opening at the one end 51 to the opening at the other end 52. The one end 51 of the optical-path cover 50 is facing the target material 11 on the target material 11 side of the outer cover 41. The other end 52 of the optical-path cover 50 is disposed so as to be facing the collector mirror 30 on the collector mirror 30 side of the outer cover 41.

The optical-path cover 50 is disposed so as to penetrate the outer cover 41. That is, the one end 51 of the optical-path cover 50 protrudes into the exhaust space 43 on the target material 11 side of the outer cover 41. The other end 52 of the optical-path cover 50 protrudes into the space on the collector mirror 30 side of the outer cover 41. The space formed on the collector mirror 30 side of the outer cover 41 is referred to as an optical-path space 46. The exhaust space 43 in which the target material 11 is disposed and the optical-path space 46 in which the collector mirror 30 is disposed are connected to each other by the optical-path cover 50. The outer cover 41 separates the exhaust space 43 in which the target material 11 is disposed from the optical-path space 46 in which the collector mirror 30 is disposed. The optical-path space 46 is preferably maintained in a high vacuum state using an exhaust pump, such as a vacuum pump.

The filter 60 is disposed so as to enclose the other end 52 (i.e., the opening at the other end 52) of the optical-path cover 50. The filter 60 is configured to let the EUV light 15 pass therethrough. An intake port 53 for introducing purge gas 44 is formed in the optical-path cover 50. For example, the intake port 53 is formed on the collector mirror 30 side of the outer cover 41 in the optical-path cover 50. The purge gas 44 introduced through the intake port 53 is injected from the one end 51 of the optical-path cover 50 toward the target material 11 and discharged from the exhaust port 42 via the exhaust space 43.

The transmissive member 70 lets the laser light 13 pass therethrough. The transmissive member 70 may be, for example, a condenser lens 70b that concentrates the laser light 13, or a glass plate 70a. Note that the transmissive member 70 is not limited to the condenser lens 70b and the glass plate 70a, and may be any other optical member as long as it can let the laser light 13 pass therethrough.

The optical-path cover 80 is disposed between the target material 11 and the transmissive member 70. The optical-path cover 80 is also referred to as a laser optical-path member. The optical-path cover 80 has a tubular shape. The optical-path cover 80 may have a conical or a truncated conical shape with a hollow interior. For example, the optical-path cover 80 has a cylindrical shape including one open end 81 and the other open end 82. Further, the width (or diameter) of the opening at the other end 82 is larger than that of the opening at the one end 81, and the width (or diameter) of the optical-path cover 80 gradually increases from the opening at the one end 81 to the opening at the other end 82. The one end 81 of the optical-path cover 80 is facing the target material 11, and the other end 82 thereof is facing the transmissive member 70.

The optical-path cover 80 may be disposed so as to penetrate the outer cover 41. That is, the one end 81 of the optical-path cover 80 protrudes into the exhaust space 43 on the target material 11 side of the outer cover 41. The other end 82 of the optical-path cover 80 protrudes into the space on the transmissive member 70 side of the outer cover 41. The space on the transmissive member 70 side of the outer cover 41 may be connected to the optical-path space 46. The exhaust space 43 in which the target material 11 is disposed and the space in which the transmissive member 70 is disposed are connected to each other by the optical-path cover 50. The outer cover 41 separates the exhaust space 43 in which the target material 11 is disposed from the optical-path space 46 in which the transmissive member 70 is disposed.

The transmissive member 70 is disposed so as to close the other end 82 (i.e., the opening at the other end 82) of the optical-path cover 80. An intake port 83 for introducing purge gas 44 is formed in the optical-path cover 80. For example, the intake port 83 is formed on the transmissive member 70 side of the outer cover 41 in the optical-path cover 80. The purge gas 44 introduced from the intake port 83 is injected from the one end 81 of the optical-path cover 80 toward the target material 11 and discharged from the exhaust port 42 via the exhaust space 43.

As described above, in the light source apparatus 1 according to this embodiment, the target material 11 is enclosed with the exhaust case 40, and the optical-path space 46 in which the EUV light 15 and the laser light 13 are disposed (i.e., travel) is separated from the exhaust space 43 in which the target material 11 is disposed. Further, the other end 52 of the optical-path cover 50 is enclosed by the filter 60, and the other end 82 of the optical-path cover 80 is enclosed by the transmissive member 70. This configuration enables a directed flow of purge gas 44 such as inert gas (Ar, He, N₂ or H₂) from the one end 81 of the optical-path cover 80, from which the laser light 13 enters, and the one end 51 of the optical-path cover 50, from which the EUV light 15 exits, toward the exhaust port 42 is formed. Therefore, the high-pressure area of the purge gas 44 and other gases is spatially restricted, which enhances debris 18 removal efficiency.

Further, by forming each of the optical-path covers 50 and 80 in a conical shape with gradually decreasing diameters toward the one end 51 and the one end 81, it is possible to efficiently increase the gas pressure and the gas flow velocity at the one end 51 and the one end 81, thereby

### enhancing the effects to remove debris 18.

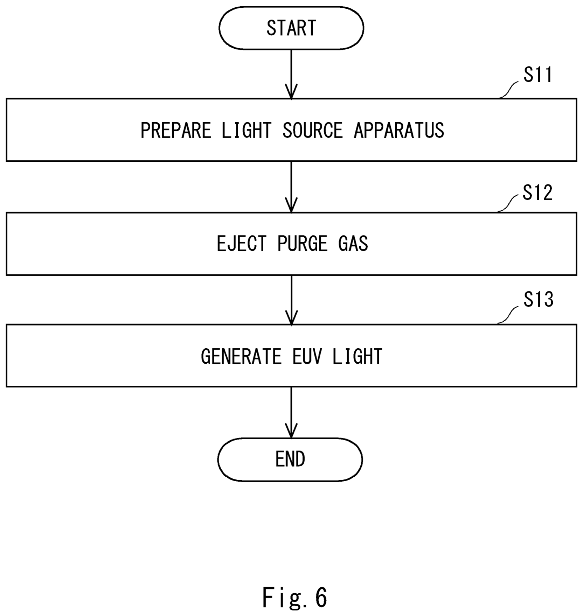

Next, as operations according to this embodiment, an illumination method using the light source apparatus 1 will be described. Fig. 6 is a flowchart showing an example of an illumination method using the light source apparatus 1 according to the first embodiment. As shown in Fig. 6, the illumination method includes a step of preparing a light source apparatus 1 (S11), a step of injecting purge gas 44 (S12), and a step of generating EUV light 15 (S13).

Firstly, as shown in Step S11, a light source apparatus 1 is prepared. The light source apparatus 1 includes a target material 11, a collector mirror 30, an exhaust case 40, an optical-path cover 50, and a filter 60. Further, the light source apparatus 1 may also include a drum 10, a supply case 20, a transmissive member 70, and an optical-path cover 80.

In Step S11, a target material 11 may be formed by supplying gas 16 for a target material 11 from a supply port 22 into a supply space 23 and solidifying the supplied gas 16 for the target material 11 on the surface of the drum 10.

Next, as shown in Step S12, purge gas 44 is injected. Specifically, purge gas 44 is introduced from an intake port 53 formed in the optical-path cover 50, and the introduced purge gas 44 is injected from the one end 51 of the optical-path cover 50 toward the target material 11. Then, the purge gas 44 is discharged from the exhaust port 42 via the exhaust space 43.

In Step S12, purge gas 44 may be introduced from an intake port 83 formed in the optical-path cover 80. The introduced purge gas 44 from the intake port 83 may be injected from the one end 81 of the optical-path cover 80 toward the target material 11. Then, the purge gas 44 may be discharged through the exhaust port 42 via an exhaust space 54.

Next, as shown in Step S13, EUV light 15 is generated. Specifically, EUV light 15 is generated by irradiating the target material 11 with laser light 13. By generating illumination light including the EUV light 15 as described above, the illumination light used in an inspection apparatus or the like can be formed.

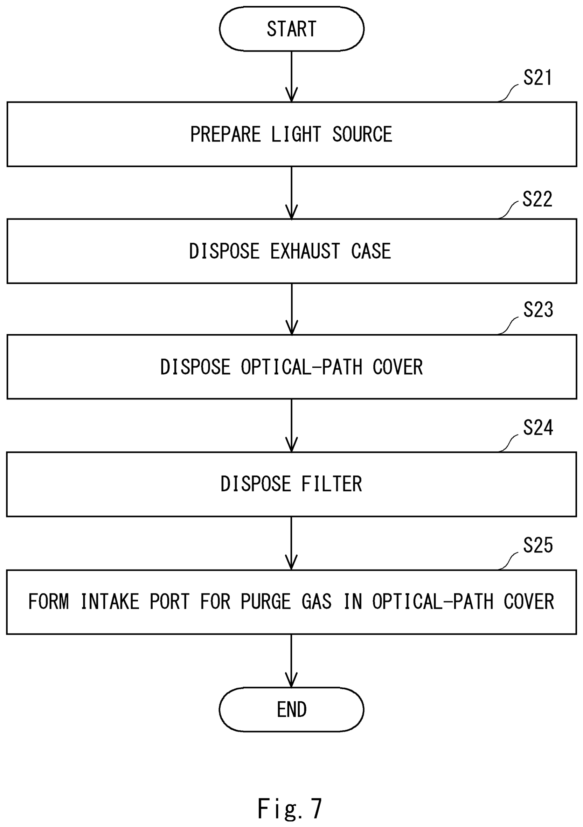

Next, a method for manufacturing a light source apparatus 1 according to this embodiment will be described. In the method for manufacturing a light source apparatus 1 according to this embodiment, for example, the light source apparatus 1 is manufactured from the light source 101 according to the comparative example. Fig. 7 is a flowchart showing an example of the method for manufacturing a light source apparatus 1 according to the first embodiment. As shown in Fig. 7, the method for manufacturing a light source apparatus 1 includes a step of preparing a light source 101 (S21), disposing an exhaust case 40 (S22), disposing an optical-path cover 50 (S23), disposing a filter 60 (S24), and forming an intake port 53 for purge gas 44 (S25). Note that the order of Steps S22 to S25 is not limited to this order. That is, the light source apparatus 1 may be manufactured in other orders, or two or more of the steps may be performed in parallel to each other.

As shown in Step S21, a light source 101 is prepared. The light source 101 includes a target material 11 and a collector mirror 30. Further, the light source 101 may also include a drum 10 and a supply case 20.

Next, as shown in Step S22, an exhaust case 40 is disposed. Specifically, an outer cover 41 is disposed between the target material 11 and the collector mirror 30. Then, an exhaust port 42 is formed so as to communicate with the exhaust space 43 formed on the target material 11 side of the outer cover 41. The outer cover 41 may be disposed so as to enclose the target material 11. In this way, the exhaust case 40 is disposed. The outer cover 41 is preferably disposed so as to separate the exhaust space 43 in which the target material 11 is disposed from the optical-path space 46 in which the collector mirror 30 is disposed. In this way, it is possible to prevent the amount of the EUV light 15 from being reduced due to the purge gas 44 and the gas 16 for the target material 11.

Next, as shown in Step S23, an optical-path cover 50 is disposed. Specifically, the optical-path cover 50 is disposed so as to penetrate the outer cover 41 in such a manner that the one end 51 thereof is facing to the target material 11 on the target material 11 side of the outer cover 41, and the other end 52 thereof is facing the collector mirror 30 on the collector mirror 30 side of the outer cover 41.

Next, as shown in Step S24, a filter 60 is disposed. Specifically, the filter 60, which lets EUV light 15 pass therethrough, is disposed so as to enclose the other end 52 of the optical-path cover 50.

Next, as shown in Step S25, an intake port 53 through which purge gas 44 is introduced to the optical-path cover 50 is formed. In this way, a light source apparatus 1 can be manufactured. Note that as will be described hereinafter, the method may further include a step of disposing an optical-path cover 80, a step of disposing a transmissive member 70, a step of forming an intake port 83, and a step of forming a target material 11.

In the step of disposing the optical-path cover 80, the optical-path cover 80 is disposed so that one end 81 thereof is facing the target material 11 and the other end 82 thereof lets the laser light 13 pass therethrough. In the step of disposing the transmissive member 70, the transmissive member 70 is disposed so that the transmissive member 70, through which laser light 13 passes, closes the other end 82 of the optical-path cover 80. In the step of forming the intake port 83, an intake port 83 for purge gas 44 is formed in the optical-path cover 80. In the step of forming the target material 11, the target material 11 is formed by supplying gas 16 for the target material 11 from the supply port 22 into the supply space 23 and solidifying the supplied gas 16 for the target material 11 on the surface of the drum 10.

Next, effects obtained in this embodiment will be described. In the light source apparatus 1 according to this embodiment, the diffusion range of the purge gas 44 and the gas 16 for the target material 11 is restricted by using the exhaust case 40, the optical-path cover 50, and the filter 60. In this way, it is possible to maintain the optical path through which the EUV light 15 travels in a high vacuum state, and thereby to suppress the absorption of the EUV light 15 by the purge gas 44 and the gas 16 for the target material 11. Therefore, it is possible to mitigate the decrease in the amount of the EUV light 15.

Since the purge gas 44 is injected from the opening at the other end 52 toward the opening at the one end 51 through the conical shape optical-path cover 50 with gradually decreasing diameters toward the one end, the flow velocity of the gas injected near the target material 11 can be increased. As a result, this enhances the force for ejecting debris, and thereby preventing contamination of optical members such as the collector mirror 30. The same applies to the optical-path cover 80.

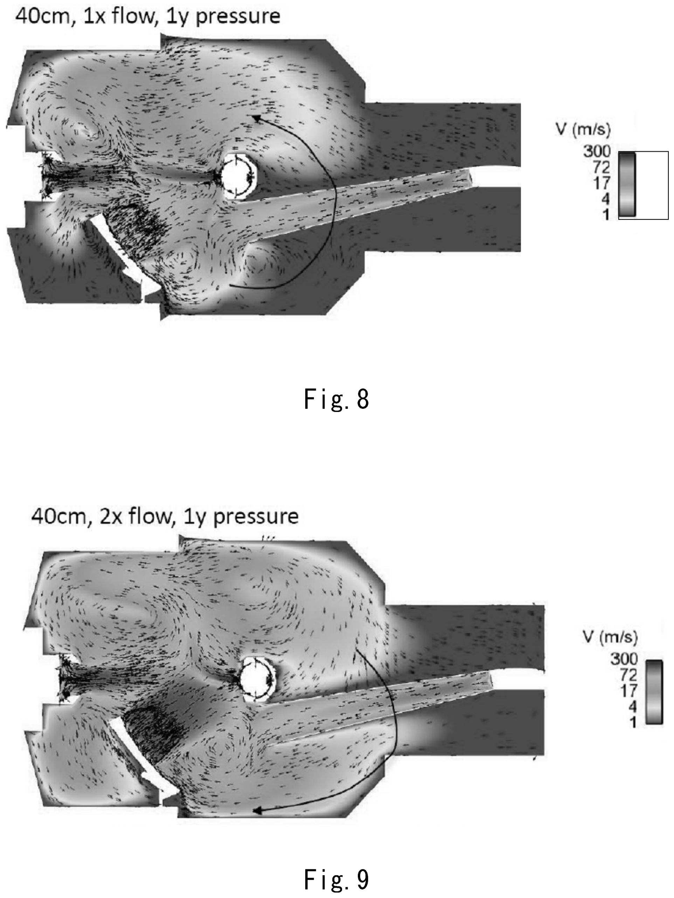

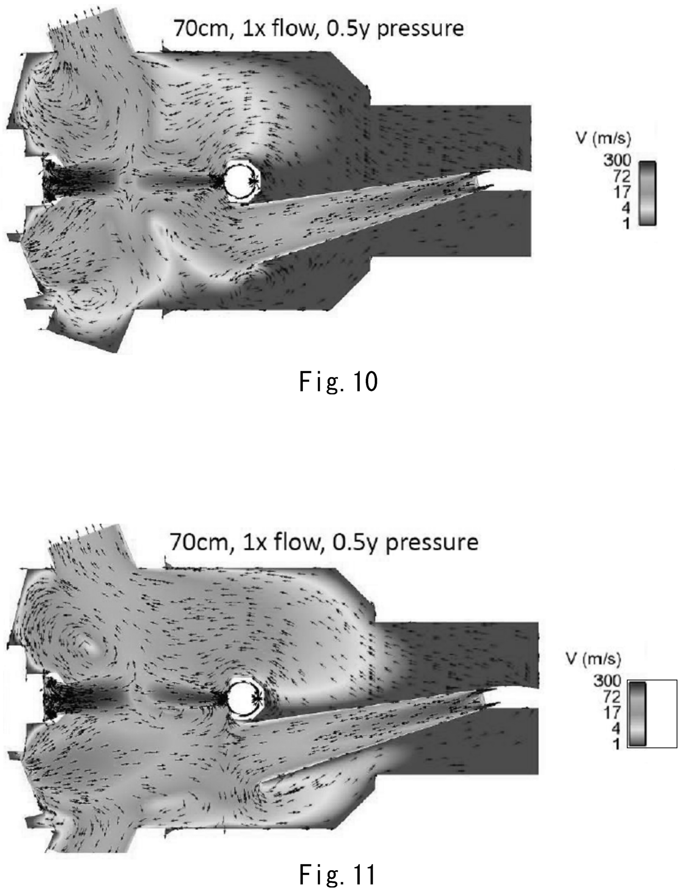

Figs. 8 to 11 show examples of the flow of purge gas 44 in the light source 101 according to the comparative example. As shown in Figs. 8 to 11, in the light source 101 according to the comparative example, the purge gas 44 is distributed in the optical paths of the laser light 13 and the EUV light 15, so that the amount of the EUV light 15 is reduced. In the light source 101 according to the comparative example, it is impossible to maintain the optical path through which the EUV light 15 travels in a high vacuum state even when the positional relationship of the collector mirror 30, the flow route and the like of the purge gas 44, and the pressure of the purge gas 44 are changed. In contrast to this, in the light source apparatus 1 according to this embodiment, the exhaust space 43 through which the purge gas 44 flows and the optical-path space 46 through which the EUV light 15 travels can be separated from each other, so that the optical path through which the EUV light 15 travels can be maintained in a high vacuum state.

### <Second Embodiment>

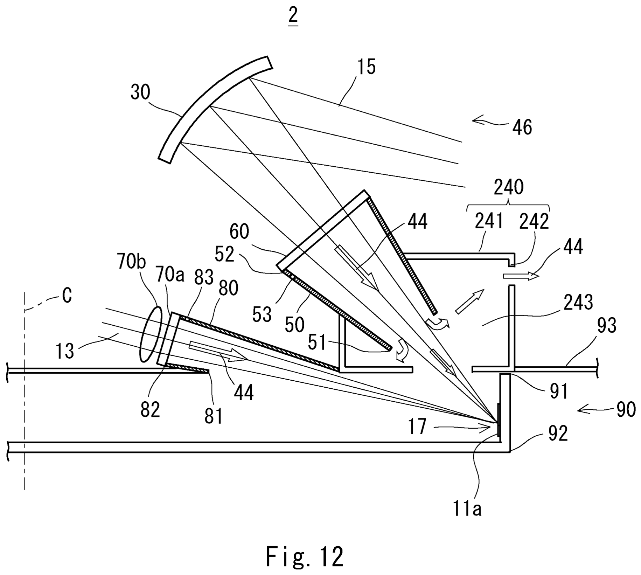

Next, a light source apparatus according to a second embodiment will be described. In the light source apparatus according to this embodiment, the target material 11 is disposed inside a crucible instead of being solidified on the surface of the drum 10. Fig. 12 is a cross-sectional view showing an example of the light source apparatus 2 according to the second embodiment. As shown in Fig. 12, the light source apparatus 2 includes a crucible 90, a debris shield 93, a target material 11a, a collector mirror 30, an exhaust case 240, an optical-path cover 50, a filter 60, a transmissive member 70, and an optical-path cover 80. The configuration of the collector mirror 30, the optical-path cover 50, the filter 60, the transmissive member 70, and the optical-path cover 80 in the light source apparatus 2 according to the second embodiment is similar to that in the light source apparatus 1 according to the first embodiment.

The crucible 90 has a central axis C. The crucible 90 rotates about the central axis C as a rotation axis. The crucible 90 has a cylindrical shape and includes one open end 91 and the other closed end 92. The crucible 210 is heated so that the target material 11a is melted on its inner surface.

The target material 11a is in a liquid state and is disposed inside the crucible 90. The target material 11a is spread over the inner peripheral surface of the crucible 90 by the centrifugal force of the rotation of the crucible 90. As described above, the target material 11a is formed by spreading the target material 11a in the liquid state over the inner surface of the crucible 90.

The one open end 91 of the crucible 90 is covered by the debris shield 93. The one end 91 of the crucible 90 and the debris shield 93 are separated from each other so as not to affect the rotation of the crucible 90. The gap between the one end 91 of the crucible 90 and the debris shield 93 is small so that the purge gas 44 does not leak therefrom, but their configuration is not limited to this example. That is, the one end 91 of the crucible 90 and the debris shield 93 may be configured so that the purge gas 44 is discharged from the gap therebetween. In this case, the exhaust case 240 includes an outer cover 241 disposed outside the cylindrical part of the crucible 90, and the outer cover 241 may include at least one exhaust port 242 facing the cylindrical part of the crucible 90 (e.g., facing the position of the gap from which the purge gas 44 leaks from the crucible 90). A part of the debris shield 93 facing the irradiation position 17 of the laser light 13 in the target material 11a is open.

The exhaust case 240 includes an outer cover 241 and an exhaust port 242. The outer cover 241 is disposed between the target material 11a and the collector mirror 30. The outer cover 241 may cover the debris shield 93. In this embodiment, the outer cover 241 has a rectangular shape of which the underside is open. A lower end of the outer cover 241 may be connected to the debris shield 93. The exhaust port 242 communicates with an exhaust space 243 formed on the target material 11a side of the outer cover 241.

The optical-path cover 50 is disposed between the target material 11a and the collector mirror 30. The one end 51 of the optical-path cover 50 is facing the target material 11a, and the other end 52 is disposed so as to be facing the collector mirror 30. The optical-path cover 50 is disposed so as to penetrate the outer cover 241. That is, the one end 51 of the optical-path cover 50 protrudes into the space on the target material 11a side of the outer cover 241. The other end 52 of the optical-path cover 50 protrudes into the space on the collector mirror 30 side of the outer cover 241. The outer cover 241 and the debris shield 93 separate the exhaust space 243 in which the target material 11a is disposed from the optical-path space 46 in which the collector mirror 30 is disposed.

The intake port 53 of the optical-path cover 50 is formed on the collector mirror 30 side of the outer cover 241 in the optical-path cover 50. Purge gas 44 introduced from the intake port 53 is injected from the one end 51 of the optical-path cover 50 toward the target material 11a and thereby discharged through the exhaust port 242 via the exhaust space 243.

The optical-path cover 80 is disposed between the target material 11a and the transmissive member 70. The one end 81 of the optical-path cover 80 is facing the target material 11a, and the other end 82 is disposed so as to be facing the transmissive member 70. The optical-path cover 80 is disposed so as to penetrate the debris shield 93. The one end 81 of the optical-path cover 80 is positioned in the space on the target material 11a side of the debris shield 93. The other end 82 of the optical-path cover 80 protrudes into the space on the transmissive member 70 side of the debris shield 93. The outer cover 241 and the debris shield 93 separate the exhaust space 243 in which the target material 11a is disposed from the optical-path space 46 in which the transmissive member 70 is disposed.

The intake port 83 of the optical-path cover 80 is formed on the transmissive member 70 side of the debris shield 93 in the optical-path cover 80. Purge gas 44 introduced from the intake port 83 is injected from the one end 81 of the optical-path cover 80 toward the target material 11a and discharged through the exhaust port 242 via the exhaust space 243.

In the illumination method using the light source apparatus 2 according to this embodiment, in Step S11, in which the light source apparatus 2 is prepared, the target material 11a (i.e., the target material 11a in the solid state) is formed by spreading the liquid target material 11a over the inner peripheral surface of the crucible 90. Further, the method for manufacturing a light source apparatus 2 according to this embodiment also includes the step of forming the target material 11a (i.e., the target material 11a in the solid state) by spreading the liquid target material 11a over the inner peripheral surface of the crucible 90.

According to this embodiment, since the light source apparatus 2 can use the liquid metal contained in the crucible 90 for the target material 11a, the choice of the target material 11a is not limited. The rest of the configuration and effects are already described in the description of the first embodiment.

### <Third Embodiment>

Next, a light source apparatus according to a third embodiment will be described. The positions of the one end 51 and the other end 52 of the optical-path cover 50 of the light source apparatus according to this embodiment are different from those of the light source apparatus 1 according to the first embodiment. Further, the positions of the one end 81 and the other end 82 of the optical-path cover 80 are also different from those in the first embodiment.

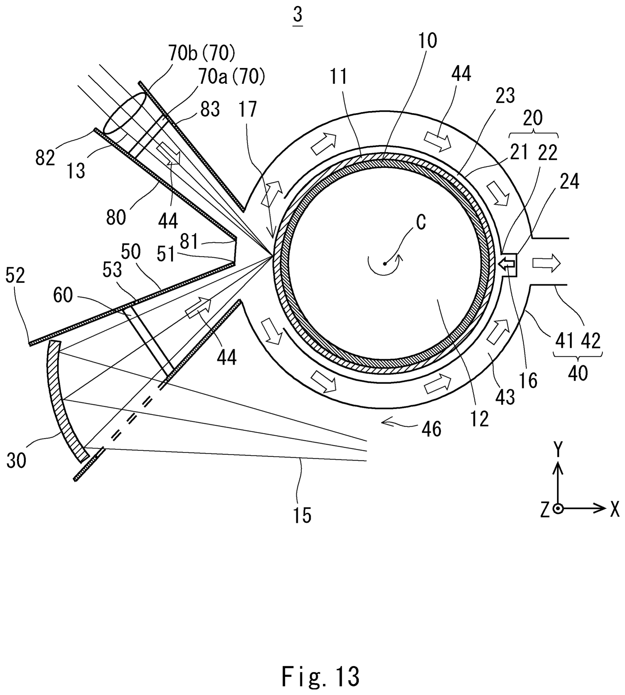

Fig. 13 is a cross-sectional view showing an example of the light source apparatus 3 according to the first embodiment. As shown in Fig. 13, in the light source apparatus 3, the optical-path cover 50 is disposed so as to house the collector mirror 30 and the filter 60 thereinside. The optical-path cover 50 includes a part having a conical or a truncated conical shape with a hollow interior but is not limited to this example. For example, the optical-path cover 50 may include a part of which the diameter does not gradually increase from the opening at the one end 51 to the opening at the other end 52. Specifically, the optical-path cover 50 has a cylindrical shape including one open end 51 and the other open end 52, and may include a part that does not have a conical nor a truncated conical shape as long as it has a cylindrical shape in which the diameter of the opening at the other end 52 is larger than that of the opening at the one end 51.

The one end 51 of the optical-path cover 50 is facing the target material 11. The one end 51 of the optical-path cover 50 is connected to the outer cover 41. As described above, the optical-path cover 50 may or may not penetrate the outer cover 41 in this embodiment. The other end 52 of the optical-path cover 50 is disposed on the collector mirror 30 side of the outer cover 41. The other end 52 of the optical-path cover 50 is positioned farther from the target material 11 than the collector mirror 30 is. That is, the collector mirror 30 and the filter 60 are disposed inside the optical-path cover 50 and are disposed between the one end 51 and the other end 52. Note that the optical-path cover 50 may have an opening in the part through which the reflected light reflected on the collector mirror 30 passes, or a transmissive member that lets the reflected light pass therethrough may be fitted in the part through which the reflected light passes.

The filter 60 is disposed on the target material 11 side of the collector mirror 30 inside the optical-path cover 50. As described above, the filter 60 in this embodiment may or may not be disposed so as to enclose the other end 52 of the optical-path cover 50.

Note that the positions of the one end 51 and the other end 52 of the optical-path cover 50 in the previously-described first embodiment and the positions of the one end 51 and the other end 52 of the optical-path cover 50 in this embodiment may be combined with each other as appropriate. That is, the one end 51 of the optical-path cover 50 may be disposed on the target material 11 side of the outer cover 41 so as to penetrate the outer cover 41, or may be connected to the outer cover 41. In each case in regard to the one end 51, the other end 52 may be connected to the filter 60 so as to be enclosed by the filter 60, or may be disposed farther from the target material 11 than the collector mirror 30 is.

The optical-path cover 80 is disposed so as to house the transmissive member 70 (e.g., at least one of the glass plate 70a and the condenser lens 70b) thereinside. The optical-path cover 80 includes a part having a conical or a truncated conical shape with a hollow interior but is not limited to this example. For example, the optical-path cover 80 may include a part of which the diameter does not gradually increase from the opening at the one end 81 to the opening at the other end 82. Specifically, the optical-path cover 80 has a cylindrical shape including one open end 81 and the other open end 82, and may include a part that does not have a conical nor a truncated conical shape as long as it has a cylindrical shape in which the diameter of the opening at the other end 82 is larger than that of the opening at the one end 81.

The one end 81 of the optical-path cover 80 is facing the target material 11. The one end 81 of the optical-path cover 80 is connected to the outer cover 41. As described above, the optical-path cover 80 may or may not penetrate the outer cover 41 in this embodiment. The other end 82 of the optical-path cover 80 is disposed on the transmissive member 70 side of the outer cover 41. The other end 82 of the optical-path cover 80 is positioned farther from the target material 11 than the transmissive member 70 is. That is, the transmissive member 70 is disposed inside the optical-path cover 80 and is disposed between the one end 81 and the other end 82.

The glass plate 70a is disposed on the target material 11 side of the condenser lens 70b inside the optical-path cover 80. As described above, the transmissive member 70 such as the glass plate 70a in this embodiment may or may not be disposed so as to close the other end 82 of the optical-path cover 80.

Note that the positions of the one end 81 and the other end 82 of the optical-path cover 80 in the previously-described first embodiment and the positions of the one end 81 and the other end 82 of the optical-path cover 80 in this embodiment may be combined with each other as appropriate. That is, the one end 81 of the optical-path cover 80 may be disposed on the target material 11 side of the outer cover 41 so as to penetrate the outer cover 41, or may be connected to the outer cover 41. In each case in regard to the one end 81, the other end 82 may be connected to the transmissive member 70 such as the glass plate 70a so as to be closed by the transmissive member 70, or may be disposed farther from the target material 11 than the transmissive member 70 is.

Further, the positions of the one end 51 and the other end 52 of the optical-path cover 50 and the positions of the one end 81 and the other end 82 of the optical-path cover 80 may be combined with each other as appropriate.

The rest of the configuration other than those described above in the third embodiment, the illumination method using the light source apparatus 3 including the configuration other than those described above, and the method for manufacturing the light source apparatus 3 including the configuration other than those described above are already described in the descriptions of the first and second embodiments.

### <Fourth Embodiment>

Next, a light source apparatus according to a fourth embodiment will be described. The positions of the one end 51 and the other end 52 of the optical-path cover 50 of the light source apparatus according to this embodiment are different from those of the light source apparatus 2 according to the second embodiment. Further, the positions of the one end 81 and the other end 82 of the optical-path cover 80 are also different from those in the second embodiment.

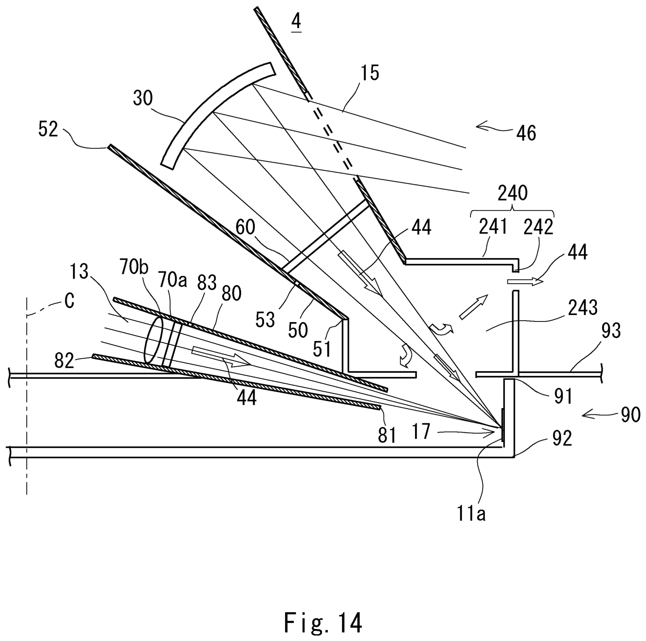

Fig. 14 is a cross-sectional view showing an example of the light source apparatus 4 according to the fourth embodiment. As shown in Fig. 14, in the light source apparatus 4, the optical-path cover 50 is disposed so as to house the collector mirror 30 and the filter 60 thereinside. The optical-path cover 50 includes a part having a conical or a truncated conical shape with a hollow interior, but is not limited to this example. For example, the optical-path cover 50 may include a part of which the diameter does not gradually increase from the opening at the one end 51 to the opening at the other end 52. Specifically, the optical-path cover 50 has a cylindrical shape including one open end 51 and the other open end 52, and may include a part that does not have a conical nor a truncated conical shape as long as it has a cylindrical shape in which the diameter of the opening at the other end 52 is larger than that of the opening at the one end 51.

The one end 51 of the optical-path cover 50 is facing the target material 11a. The one end 51 of the optical-path cover 50 is connected to the outer cover 241. As described above, the optical-path cover 50 may or may not penetrate the outer cover 241 in this embodiment. The other end 52 of the optical-path cover 50 is disposed on the collector mirror 30 side of the outer cover 241. The other end 52 of the optical-path cover 50 is positioned farther from the target material 11a than the collector mirror 30 is. That is, the collector mirror 30 and the filter 60 are disposed inside the optical-path cover 50 and are disposed between the one end 51 and the other end 52. Note that the optical-path cover 50 may have an opening in the part through which the reflected light reflected on the collector mirror 30 passes, or a transmissive member that lets the reflected light pass therethrough may be fitted in the part through which the reflected light passes.

The filter 60 is disposed on the target material 11a side of the collector mirror 30 inside the optical-path cover 50. As described above, the filter 60 in this embodiment may or may not be disposed so as to close the other end 52 of the optical-path cover 50.

Note that the positions of the one end 51 and the other end 52 of the optical-path cover 50 in the previously-described second embodiment and the positions of the one end 51 and the other end 52 of the optical-path cover 50 in this embodiment may be combined with each other as appropriate. That is, the one end 51 of the optical-path cover 50 may be disposed on the target material 11a side of the outer cover 241 so as to penetrate the outer cover 241, or may be connected to the outer cover 241. In each case in regard to the one end 51, the other end 52 may be connected to the filter 60 so as to be closed by the filter 60, or may be disposed farther from the target material 11 than the collector mirror 30 is.

The optical-path cover 80 is disposed so as to house the transmissive member 70 (e.g., at least one of the glass plate 70a and the condenser lens 70b) thereinside. The optical-path cover 80 includes a part having a conical or a truncated conical shape with a hollow interior, but is not limited to this example. For example, the optical-path cover 80 may include a part of which the diameter does not gradually increase from the opening at the one end 81 to the opening at the other end 82. Specifically, the optical-path cover 80 has a cylindrical shape including one open end 81 and the other open end 82, and may include a part that does not have a conical nor a truncated conical shape as long as it has a cylindrical shape in which the diameter of the opening at the other end 82 is larger than that of the opening at the one end 81.

The one end 81 of the optical-path cover 80 is facing the target material 11a. The one end 81 of the optical-path cover 80 penetrates the outer cover 241. As described above, the one end 81 of the optical-path cover 80 may or may not be connected to the outer cover 241 in this embodiment. The other end 82 of the optical-path cover 80 is disposed on the transmissive member 70 side of the outer cover 241. The other end 82 of the optical-path cover 80 is positioned farther from the target material 11a than the transmissive member 70 is. That is, the transmissive member 70 is disposed inside the optical-path cover 80 and is disposed between the one end 81 and the other end 82.

The glass plate 70a is disposed on the target material 11 side of the condenser lens 70b inside the optical-path cover 80. As described above, the transmissive member 70 such as the glass plate 70a in this embodiment may or may not be disposed so as to close the other end 82 of the optical-path cover 80.

Note that the positions of the one end 81 and the other end 82 of the optical-path cover 80 in the previously-described first embodiment and the positions of the one end 81 and the other end 82 of the optical-path cover 80 in this embodiment may be combined with each other as appropriate. That is, the one end 81 of the optical-path cover 80 may be disposed on the target material 11a side of the outer cover 241 so as to penetrate the outer cover 241, or may be connected to the outer cover 241. In each case in regard to the one end 81, the other end 82 may be connected to the transmissive member 70 such as the glass plate 70a so as to be closed by the transmissive member 70, or may be disposed farther from the target material 11 than the transmissive member 70 is.

Further, the positions of the one end 51 and the other end 52 of the optical-path cover 50 and the positions of the one end 81 and the other end 82 of the optical-path cover 80 may be combined with each other as appropriate.

The rest of the configuration other than those described above in the fourth embodiment, the illumination method using the light source apparatus 4 including the configuration other than those described above, and the method for manufacturing the light source apparatus 4 including the configuration other than those described above are already described in the descriptions of the first to third embodiments.

Although embodiments according to the present disclosure have been described above, the present disclosure includes modifications that do not impair the purpose and advantages thereof, and is not limited by the above-described embodiments. Those that are obtained by combining some components/structures in comparative examples and those in the first and second embodiments are also included in the technical concept of the present disclosure.

Further, light source apparatuses, illumination methods, and methods for manufacturing light source apparatuses described below are also included in the technical concept of the present disclosure.

### (Supplementary note 1)

A light source apparatus comprising:
a target material capable of generating EUV light together with plasma when irradiated with laser light;
a collector mirror configured to reflect the generated EUV light;
an exhaust case including an outer cover disposed between the target material and the collector mirror, and an exhaust port communicating with an exhaust space formed on a target material side of the outer cover;
a cylindrical optical-path cover including one open end and another open end, a diameter of an opening at the other end being larger than that of an opening at the one end, and a diameter of the optical-path cover gradually increasing from the opening at the one end toward the opening at the other end, the one end facing the target material on a target material side of the outer cover, and the other end being disposed so as to penetrate the outer cover in such a manner that the other end facing the collector mirror on a collector mirror side of the outer cover; and
a filter configured to close the other end of the optical-path cover and let the EUV light pass therethrough, wherein
purge gas introduced from an intake port formed in the optical-path cover is injected from the one end of the optical-path cover toward the target material and discharged through the exhaust port via the exhaust space.

### (Supplementary note 2)

The light source apparatus described in Supplementary note 1, further comprising:
a transmissive member configured to let the laser light pass therethrough; and
a cylindrical laser optical-path cover including one open end and another open end, a diameter of an opening at the other end being larger than that of an opening at the one end, and a diameter of the laser optical-path cover gradually increasing from the opening at the one end toward the opening at the other end, the one end of the laser optical-path cover facing the target material, and the other end of the laser optical-path cover being disposed so as to be facing the transmissive member of the laser optical-path cover, wherein
the transmissive member closes the other end of the laser optical-path cover, and
the purge gas introduced from an intake port formed in the laser optical-path cover is injected from the one end of the laser optical-path cover toward the target material and discharged through the exhaust port via the exhaust space.

### (Supplementary note 3)

An illumination method comprising:
a step of preparing a light source apparatus including:
a target material capable of generating EUV light together with plasma when being irradiated with laser light;
a collector mirror configured to reflect the generated EUV light;
an exhaust case including an outer cover disposed between the target material and the collector mirror, and an exhaust port communicating with an exhaust space formed on a target material side of the outer cover;
a cylindrical optical-path cover including one open end and another open end, a diameter of an opening at the other end being larger than that of an opening at the one end, and a diameter of the optical-path cover gradually increasing from the opening at the one end toward the opening at the other end, the one end facing the target material on a target material side of the outer cover, and the other end being disposed so as to penetrate the outer cover in such a manner that the other end is facing the collector mirror on a collector mirror side of the outer cover; and
a filter configured to enclose the other end of the optical-path cover and let the EUV light pass therethrough;
a step of feeding purge gas from an intake port formed in the optical-path cover, and injecting the fed purge gas from the one end of the optical-path cover toward the target material and thereby discharging the purge gas from the exhaust port through the exhaust space; and
a step of generating the EUV light by irradiating the target material with the laser light.

### (Supplementary note 4)

The illumination method described in Supplementary note 3, wherein
the light source apparatus comprises:
a transmissive member configured to let the laser light pass therethrough; and
a cylindrical laser optical-path cover including one open end and another open end, a diameter of an opening at the other end being larger than that of an opening at the one end, and a diameter of the laser optical-path cover gradually increasing from the opening at the one end toward the opening at the other end, the one end of the laser optical-path cover facing the target material, and the other end of the laser optical-path cover being disposed so as to be facing the transmissive member of the laser optical-path cover, and
in the step of discharging the purge gas from the exhaust port, the purge gas is fed from an intake port formed in the laser optical-path cover, and the fed purge gas is injected from the one end of the laser optical-path cover toward the target material and discharged through the exhaust port via the exhaust space.

### (Supplementary note 5)

A method for manufacturing a light source apparatus, comprising: a step of preparing a light source apparatus comprising:
a target material capable of generating EUV light together with plasma when being irradiated with laser light; and
a collector mirror configured to reflect the generated EUV light;
a step of disposing an outer cover between the target material and the collector mirror, and disposing an exhaust case by forming an exhaust port so that the exhaust port communicates with an exhaust space formed on a target material side of the outer cover;
a step of disposing a cylindrical optical-path cover including one open end and another open end, in which a diameter of an opening at the other end is larger than that of an opening at the one end, and a diameter of the optical-path cover gradually increases from the opening at the one end toward the opening at the other end, so as to penetrate the outer cover in such a manner that the one end is facing the target material on the target material side of the outer cover and the other end is disposed so as to be facing the collector mirror on a collector mirror side of the outer cover;
a step of closing the other end of the optical-path cover by a filter configured to let the EUV light pass therethrough; and
a step of forming an intake port through which purge gas is fed to the optical-path cover.

### (Supplementary note 6)

The method for manufacturing a light source apparatus described in Supplementary note 5, further comprising:
a step of disposing a cylindrical laser optical-path cover including one open end and another open end, in which a diameter of an opening at the other end is larger than that of an opening at the one end, and a diameter of the laser optical-path cover gradually increases from the opening at the one end toward the opening at the other end, so that the one end of the laser optical-path cover is facing the target material and the other end of the laser optical-path cover is disposed so as to let the laser light pass therethrough;
a step of closing the other end of the laser optical-path cover with a transmissive member through which the laser light passes; and
a step of forming an intake port through which purge gas is fed to the laser optical-path cover.

This application is based upon and claims the benefit of priority from Japanese patent application No. 2023-070595, filed on April 24, 2023, the disclosure of which is incorporated herein in its entirety by reference.

### Reference Signs List

- 1, 2, 3, 4: LIGHT SOURCE APPARATUS
- 10: DRUM
- 11, 11a: TARGET MATERIAL
- 12: COOLING MATERIAL
- 13: LASER LIGHT
- 14: PLASMA
- 15: EUV LIGHT
- 16: GAS
- 17: IRRADIATION POSITION
- 18: DEBRIS
- 20: SUPPLY CASE
- 21: HOUSING
- 22: SUPPLY PORT
- 23: SUPPLY SPACE
- 24: SUPPLY UNIT
- 25: WIPER
- 26: VACUUM SEAL
- 27: INTAKE PORT
- 28: WINDOW
- 30: COLLECTOR MIRROR
- 40: EXHAUST CASE
- 41: OUTER COVER
- 42: EXHAUST PORT
- 43: EXHAUST SPACE
- 44: PURGE GAS
- 46: OPTICAL PATH
- 50: OPTICAL-PATH COVER
- 51: ONE END
- 52: OTHER END
- 53: INLET
- 60: FILTER
- 70: TRANSMISSION MEMBER
- 70a: GLASS PLATE
- 70b: CONDENSER LENS
- 80: OPTICAL-PATH COVER
- 81: ONE END
- 82: OTHER END
- 83: INLET
- 90: CRUCIBLE
- 91: ONE END
- 92: OTHER END
- 93: DEBRIS SHIELD
- 101: LIGHT SOURCE
- 240: EXHAUST CASE
- 241: OUTER COVER
- 242: EXHAUST PORT
- 243: EXHAUST SPACE
- C: CENTRAL AXIS

## Claims

1. A light source apparatus comprising:
a target material capable of generating EUV light together with plasma when irradiated with laser light;
a collector mirror configured to reflect the generated EUV light;
an exhaust case including an outer cover disposed between the target material and the collector mirror, and an exhaust port communicating with an exhaust space formed on a target material side of the outer cover;
a tubular optical-path cover including one open end and another open end, a width of an opening at the other end being larger than that of an opening at the one end, and the one end facing the target material and the other end being disposed on a collector mirror side of the outer cover; and
a filter disposed at the other end of the optical-path cover or inside the optical-path cover, and configured to let the EUV light pass therethrough, wherein
purge gas introduced from an intake port formed in the optical-path cover is injected from the one end of the optical-path cover toward the target material and thereby discharged through the exhaust port via the exhaust space.

2. A light source apparatus comprising:
a target material capable of generating EUV light together with plasma when being irradiated with laser light;
a collector mirror configured to reflect the generated EUV light;
an exhaust case including an outer cover disposed between the target material and the collector mirror, and an exhaust port communicating with an exhaust space formed on a target material side of the outer cover;
a transmissive member configured to let the laser light pass therethrough; and
a tubular laser optical-path cover including one open end and another open end, a width of an opening at the other end being larger than that of an opening at the one end, the one end of the laser optical-path cover facing the target material, and the transmissive member being disposed at the other end of the laser optical-path cover or inside the laser optical-path cover, wherein
purge gas introduced from an intake port formed in the laser optical-path cover is injected from the one end of the laser optical-path cover toward the target material and thereby discharged from the exhaust port through the exhaust space.

3. The light source apparatus according to claim 1 or 2, wherein the outer cover separates the exhaust space in which the target material is disposed from an optical-path space in which the collector mirror is disposed.

4. The light source apparatus according to claim 1 or 2, further comprising:
a cylindrical drum configured to rotate about a central axis serving as a rotation axis, and configured to be cooled so that the target material is solidified on its surface; and
a supply case including a housing of which an open portion is facing an irradiation position of the laser light, and a supply port communicating with a supply space formed on a target material side of the housing, wherein
the target material may be formed as gas for the target material, supplied from the supply port is solidified on the surface of the drum.

5. The light source apparatus according to claim 1 or 2, further comprising:
a cylindrical crucible configured to rotate about a central axis as a rotation axis, including one open end and another closed end, and configured to be heated so that the target material is melted on its inner surface; and
a debris shield having an open portion facing an irradiation position of the laser light, wherein
the target material may be formed by spreading the liquid target material over an inner peripheral surface of the crucible.

6. An illumination method comprising:
a step of preparing a light source apparatus including:
a target material capable of generating EUV light together with plasma when being irradiated with laser light;
a collector mirror configured to reflect the generated EUV light; an exhaust case including an outer cover disposed between the target material and the collector mirror, and an exhaust port communicating with an exhaust space formed on a target material side of the outer cover;
a tubular optical-path cover including one open end and another open end, a width of an opening at the other end being larger than that of an opening at the one end, and the one end facing the target material and the other end being disposed on a collector mirror side of the outer cover; and
a filter disposed at the other end of the optical-path cover or inside the optical-path cover, and configured to let the EUV light pass therethrough;
a step of introducing purge gas from an intake port formed in the optical-path cover, and injecting the introduced purge gas from the one end of the optical-path cover toward the target material and discharging the purge gas through the exhaust port via the exhaust space; and
a step of generating the EUV light by irradiating the target material with the laser light.

7. An illumination method comprising:
a step of preparing a light source apparatus including:
a target material capable of generating EUV light together with plasma when being irradiated with laser light;
a collector mirror configured to reflect the generated EUV light; an exhaust case including an outer cover disposed between the target material and the collector mirror, and an exhaust port communicating with an exhaust space formed on a target material side of the outer cover;
a transmissive member configured to let the laser light pass therethrough; and
a tubular laser optical-path cover including one open end and another open end, a width of an opening at the other end being larger than that of an opening at the one end, the one end of the laser optical-path cover facing the target material, and the transmissive member being disposed at the other end of the laser optical-path cover or inside the laser optical-path cover;
a step of introducing purge gas from an intake port formed in the laser optical-path cover, and injecting the introduced purge gas from the one end of the laser optical-path cover toward the target material and discharging the purge gas through the exhaust port via the exhaust space; and
a step of generating the EUV light by irradiating the target material with the laser light.

8. The illumination method according to claim 6 or 7, wherein the outer cover separates the exhaust space in which the target material is disposed from an optical-path space in which the collector mirror is disposed.

9. The illumination method according to claim 6 or 7, wherein
the light source apparatus further comprises:
a cylindrical drum configured to rotate about a central axis as a rotation axis, and configured to be cooled so that the target material is solidified on its surface; and
a supply case including a housing having an open portion facing an irradiation position of the laser light, and a supply port communicating with a supply space formed on a target material side of the housing, and
in the step of preparing the light source apparatus, the target material is formed by supplying gas for the target material from the intake port into the supply space, and solidifying the supplied gas for the target material on the surface of the drum.

10. The illumination method according to claim 6 or 7, wherein
the light source apparatus further comprises:
a cylindrical crucible configured to rotate about a central axis as a rotation axis, including one open end and another closed end, and configured to be heated so that the target material is melted on its inner surface; and
a debris shield of which an open portion is facing an irradiation position of the laser light, and
in the step of preparing the light source apparatus, the target material is formed by spreading the liquid target material over an inner peripheral surface of the crucible.

11. A method for manufacturing a light source apparatus, comprising:
a step of preparing a light source apparatus comprising:
a target material capable of generating EUV light together with plasma when being irradiated with laser light; and
a collector mirror configured to reflect the generated EUV light;
a step of disposing an outer cover between the target material and the collector mirror, and disposing an exhaust case by forming an exhaust port so that the exhaust port communicates with an exhaust space formed on a target material side of the outer cover;
a step of disposing a tubular optical-path cover including one open end and another open end, in which a width of an opening at the other end is larger than that of an opening at the one end, so that the one end is facing the target material and the other end is disposed on a collector mirror side of the outer cover;
a step of disposing a filter at the other end of the optical-path cover or inside the optical-path cover, the filter being configured to let the EUV light pass therethrough; and
a step of forming an intake port through which purge gas is fed to the optical-path cover.

12. A method for manufacturing a light source apparatus, comprising:
a step of preparing a light source apparatus comprising:
a target material capable of generating EUV light together with plasma when being irradiated with laser light; and
a collector mirror configured to reflect the generated EUV light;
a step of disposing an outer cover between the target material and the collector mirror, and disposing an exhaust case by forming an exhaust port so that the exhaust port communicates with an exhaust space formed on a target material side of the outer cover;
a step of disposing a tubular laser optical-path cover including one open end and another open end, in which a width of an opening at the other end is larger than that of an opening at the one end, so that the one end of the laser optical-path cover is facing the target material and the other end of the laser optical-path cover is disposed so as to let the laser light pass therethrough;
a step of disposing a transmissive member at the other end of the laser optical-path cover or inside the laser optical-path cover, the transmissive member being configured to let the laser light pass therethrough; and
a step of forming an intake port through which purge gas is fed to the laser optical-path cover.

13. The method for manufacturing a light source apparatus according to claim 11 or 12, wherein the outer cover is disposed so as to separate the exhaust space in which the target material is disposed from an optical-path space in which the collector mirror is disposed.

14. The method for manufacturing a light source apparatus according to claim 11 or 12, wherein
the light source may further include:
a cylindrical drum configured to rotate about a central axis serving as a rotation axis, and configured to be cooled so that the target material is solidified on its surface; and
a supply case including a housing of which an open portion is facing an irradiation position of the laser light, and a supply port communicating with a supply space formed on a target material side of the housing, and
the method may further include a step of forming the target material by supplying gas for the target material from the intake port into the supply space, and solidifying the supplied gas for the target material on the surface of the drum.

15. The method for manufacturing a light source apparatus according to claim 11 or 12, wherein
the light source further comprises:
a cylindrical crucible configured to rotate about a central axis serving as a rotation axis, including one open end and another closed end, and configured to be heated so that the target material is melted on its inner surface; and
a debris shield of which an open portion is facing an irradiation position of the laser light, and
the method further includes a step of forming the target material by spreading the liquid target material over an inner peripheral surface of the crucible.
